# EUROPÄISCHE PATENTSCHRIFT

(11) **EP 1 627 094 B1**
(45) Veröffentlichungstag und Bekanntmachung des Hinweises auf die Patenterteilung: **24.10.2018**
(21) Anmeldenummer: 04722780.6
(22) Anmeldetag: 24.03.2004
(51) Int. Cl.: C23C 14/06, C23C 14/00, C23C 30/00, C23C 14/02, C23C 14/58, C23C 14/32, C23C 28/04

(54) **WERKSTÜCK MIT ALCR-HALTIGER HARTSTOFFSCHICHT**
WORKPIECE COMPRISING AN ALCR-CONTAINING HARD MATERIAL LAYER
PIECE A USINER COMPORTANT UNE COUCHE DE MATIERE DURE CONTENANT ALCR

(30) Priorität: 28.04.2003 US 465995 P; 17.10.2003 US 512590 P; 13.11.2003 WO PCT/CH03/00746
(43) Veröffentlichungstag der Anmeldung: 22.02.2006
(60) Teilanmeldung: 10010250.8
(73) Patentinhaber: Oerlikon Surface Solutions AG, Pfäffikon, 8808 Pfäffikon (CH)
(72) Erfinder: DERFLINGER, Volker, 6800 Feldkirch (AT); REITER, Andreas, 6800 Feldkirch (AT); GEY, Christoph, FL-9496 Balzers (LI)
(86) Internationale Anmeldenummer: PCT/CH2004/000180
(87) Internationale Veröffentlichungsnummer: WO 2004/059030

(56) Entgegenhaltungen:
- EP-A- 1 422 311
- US-A1- 2003 035 894
- PATENT ABSTRACTS OF JAPAN Bd. 1998, Nr. 05, 30. April 1998 (1998-04-30) -& JP 10 025566 A (YAMAGUCHI PREF GOV), 27. Januar 1998 (1998-01-27) & Automatische Englische Übersetzung von JP-A-10 025566 (Quelle: Japanische Patentamt)
- PATENT ABSTRACTS OF JAPAN Bd. 1997, Nr. 06, 30. Juni 1997 (1997-06-30) -& JP 09 041127 A (KOBE STEEL LTD), 10. Februar 1997 (1997-02-10) in der Anmeldung erwähnt
- KUNISCH C ET AL: "THERMODYNAMIC MODELING OF AL-CR-N THIN FILM SYSTEMS GROWN BY PVD" ZEITSCHRIFT FUR METALLKUNDE, HANSER, MUNCHEN, DE, Bd. 90, Nr. 10, Oktober 1999 (1999-10), Seiten 847-852, XP009032148 ISSN: 0044-3093
- KAWATE MASAHIRO ET AL: "Microhardness and lattice parameter of Cr1-xAlxN films" JOURNAL OF VACUUM SCIENCE AND TECHNOLOGY A. VACUUM, SURFACES AND FILMS, AMERICAN INSTITUTE OF PHYSICS, NEW YORK, NY, US, Bd. 20, Nr. 2, März 2002 (2002-03), Seiten 569-571, XP012005996 ISSN: 0734-2101
- SANCHETTE F ET AL: "Mechanically reinforced and corrosion-resistant sputtered amorphous aluminium alloy coatings" SURFACE AND COATINGS TECHNOLOGY ELSEVIER SWITZERLAND, Bd. 98, Nr. 1-3, Januar 1998 (1998-01), Seiten 1162-1168, XP002347450 ISSN: 0257-8972
- IDE Y ET AL: "FORMATION OF AL-CR-N FILMS BY A DC REACTIVE SPUTTERING METHOD AND EVALUATION OF THEIR PROPERTIES" PROCEEDINGS OF THE INTERNATIONAL CONFERENCE ON PROCESSING MATERIALS FOR PROPERTIES, 5. November 2000 (2000-11-05), Seiten 291-296, XP009032149
- VETTER J ET AL: "(Cr:Al)N coatings deposited by the cathodic vacuum arc evaporation" SURFACE AND COATINGS TECHNOLOGY ELSEVIER SWITZERLAND, Bd. 98, Nr. 1-3, Januar 1998 (1998-01), Seiten 1233-1239, XP002347451 ISSN: 0257-8972

## Beschreibung

Das technische Gebiet auf das sich die Erfindung bezieht sind Werkstücke die mit einem Schichtsystem das zumindest eine Schicht der Zusammensetzung (Al_{y}Cr_{1-y}) X gemäss Anspruch 1 und 2 enthält, beschichtet sind.

Im Einzelnen umfasst die Erfindung:
- Hartstoffbeschichtete Werkstücke, mit einer oder einer Abfolge mehrere unterschiedlicher Aluminiumchromnitrid, bzw. - carbonitrid Schichten.
- Werkzeuge, insbesondere Schneid- und Umformwerkzeuge (Bohrer, Fräser, Wendeschneidplatten, Gewindebohrer, -former, Abwälzfräser, Stempel, Matrizen, Ziehstempel, etc.) und Anwendung dieser Werkzeuge mit Aluminiumchromnitrid, bzw. -carbonitrid Schichten.
- Bauteile, insbesondere Bauteile aus dem Maschinenbaubereich wie beispielsweise Zahnräder, Pumpen, Tassenstössel, Kolbenringe, Injektornadeln, komplette Lagersätze oder deren einzelne Bestandteile und Anwendungen dieser Bauteile mit AlCrN bzw. AlCrCN - Schichten.

Aus dem bisherigen Stand der Technik sind verschiedene AlCrN-Schichten bekannt. So beschreibt JP 09-041127 eine verschleissbeständige Hartschicht folgender Zusammensetzung: (Al_{1-y}X_{y}) Z, wobei X = Cr, V oder Mg, Z = N, C, B, CN, BN od. CBN und 0 < Y ≤ 0.3. Diese Schicht wurde vorteilhaft für die Erhöhung der Standzeit auf Wendeschneidplatten eingesetzt.

K. Masahiro et al erwähnen in ihrer wissenschaftlichen Veröffentlichung "Microhardness and lattice parameter of Cr1-xAlxN films" in der Zeitschrift "J. Vac. Sci. Technol." Bd. 20, Nr. 2, März 2012 (2002-03), S. 569-571, dass Cr₁₋ₓAlₓN ein von den vielversprechenden Nitriden für Schichten für Schneidwerkzeuge und Metallformen ist.

D. Schulz und R. Wilberg beschreiben in "Multicomponent hard thin films ...", Thin films (Proc. 4th int. Sympos. Trends & New Applictions of Thin Films 1993) DGM Info.gesellschaft Oberursel, 1993, S. 73, eine CrAlN Schicht, die bei einem Bohrtest die doppelte Standzeit eines TiAlN beschichteten Bohrers erzielt. Die Abscheidung der Schicht erfolgte mit einem Hohlkathodenprozess, der jedoch auf Grund eines diskontinuierlichen Verdampfungsprozesses eine starke Schwankung der Chrom/Aluminiumverteilung in der (CrAl)N-Schicht bewirkt.

M.Kawate et al. erwähnt in "Oxidation resistance of Cr1-xAlxN & Ti1-xAlxN films", Surf. & Coat. Tech., Vol.165, 2, (2003), p163-167 eine Cr₁₋ₓAlₓN Schicht, die bei bei hohem Al-Gehalt und Wurtzitstruktur eine gegenüber herkömmlichen TiAlN-Schiehten verbesserte Oxidationsbeständigkeit aufweist.

E. Lugscheider, K. Bobzin, K. Lackner vergleichen in "Investigations of Mechanical & Tribol Properties of CrAlN + C Thin Coatings Deposited on Cutting Tools" gearcte CrAlN-Schichten und CrAlN-Schichten die zusätzlich mit einer noch härteren, kohlenstoffhaltigen Deckschicht versehen sind. Alle Schichten weisen einen rasch auf hohe Werte ansteigenden Reibungskoeffizienten auf.

Technische Aufgabenstellung der vorliegenden Erfindung ist es, (Al_{y}Cr_{1-y}) X beschichtete Werkstücke, wie zum Beispiel Zerspanungswerkzeuge, Schneid- & Formwerkzeuge bzw. Bauteile für den Maschinen- & Formenbau zur Verfügung zu stellen und dabei die Nachteile des Standes der Technik zu vermeiden.

Dies umfasst beispielsweise Werkstücke, die zumindest bezüglich des Al/Cr-Verhältnis eine einstellbare gleichmässige oder veränderbare Schichtzusammensetzung besitzen, und zumindest bei bestimmten Anwendungen eine höhere Verschleissfestigkeit aufweisen als mit bisher bekannten Schichten versehene Werkstücke.

Um die Verschleissbeständigkeit von (Al_{y}Cr_{1-y})N bzw. -CN Schichten auf verschiedenen Werkzeugen zu untersuchen, wurde auf verschiedenen Werkstücken in einer industriellen Beschichtungsanlage vom Typ RCS der Firma Balzers, wie beispielsweise auch in EP 1186681 in Fig. 3-6, Beschreibung Seite 12, Zeile 26 bis Seite 14, Zeile 9 beschrieben, Cr-Schichten mit unterschiedlichem Aluminiumgehalt abgeschieden. Die genannte Schrift wird hiermit zum integralen Bestandteil dieser Anmeldung erklärt. Dazu wurden die gereinigten Werkstücke je nach Durchmesser auf zwei- bzw. für Durchmesser kleiner 50 mm auf dreifach rotierende Substratträger befestigt und zwei Titan- und vier pulvermetallurgisch hergestellte Targets aus unterschiedlichen AlCr-Legierungen in sechs an den Wänden der Beschichtungsanlage angebrachten kathodischen Arcquellen eingebaut.

Anschliessend wurden zunächst die Werkstücke durch ebenfalls in der Anlage angebrachte Strahlungsheizungen auf eine Temperatur von ca. 500°C gebracht und die Oberfläche durch Anlegen einer Biasspannung von -100 bis -200 V unter Ar-Atmosphäre bei einem Druck von 0,2 Pa einer Ätzreinigung durch Ar-Ionen unterzogen.

Im Folgenden wurde durch Betrieb der zwei Ti-Quellen mit einer Leistung von 3,5 kW (140 A), in reiner Stickstoffatmosphäre, bei einem Druck von 3 Pa und einer Substratspannung von -50 V während einer Zeit von 5 Minuten eine ca. 0.2 µm dicke TiN Haftschicht, und anschliessend, durch Betrieb der vier AlCr-Quellen mit einer Leistung von 3kW für die Dauer von 120 Minuten, eine AlCrN-Schicht abgeschieden. Zur Erzielung eines optimierten Schichtübergangs wurden die Quellen während einer Zeit von 2 Minuten gemeinsam betrieben. Danach wurde eine nitridische Schicht auf AlCr-Basis in reiner Stickstoffatmosphäre, ebenfalls bei einem Druck von 3 Pa und einer Substratspannung von -50V abgeschieden. Grundsätzlich kann der Prozessdruck bei jedem dieser Schritte in einem Bereich von 0.5 bis ca. 8 Pa, bevorzugt zwischen 2.5 und 5 Pa eingestellt werden, wobei entweder eine reine Stickstoffatmosphäre oder eine Mischung von Stickstoff und einem Edelgas, wie z.B. Argon für nitridische Schichten, bzw. eine Mischung aus Stickstoff und einem kohlenstoffhaltigen Gas, der bei Bedarf ein Edelgas zugemischt wird, für carbonitridische Schichten verwendet werden kann. Dementsprechend kann für die Abscheidung sauerstoff- bzw. borhaltiger Schichten Sauerstoff bzw. ein borhaltiges Gas wie bekannt zugemischt werden.

Schichteigenschaften wie Kristallstruktur der Schicht, Schichtdicke, Schichthärte, Verschleisswiderstand und Haftung von AlCrN-Schichten in Abhängigkeit der chemischen Zusammensetzung und Kristallstruktur sowie die Zusammensetzung der verwendeten Targets sind in Tabelle 1 angeführt. Prozessparameter wie Targetleistung, Substratvorspannung, Prozessdruck und Temperatur sind in Tabelle 2 zusammengefasst.

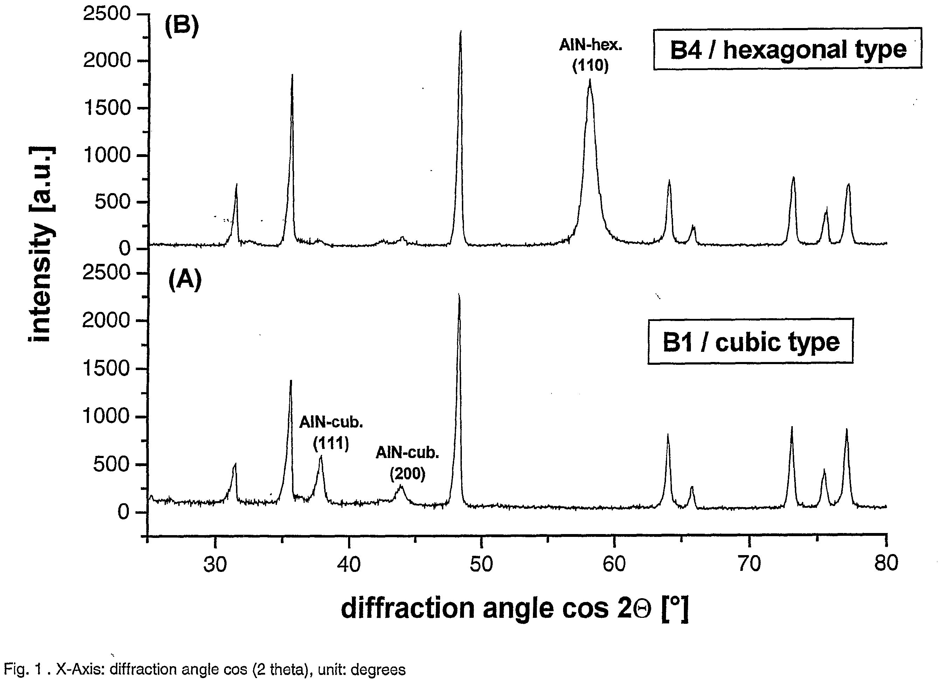

In Tabelle 3 ist eine Messreihe angeführt, bei der AlCrN-Schichten unter Verwendung von Targets mit einem Al/Cr-Verhältnis gleich 3, unter Anlegung unterschiedlicher Substratspannungen abgeschieden worden sind. Dabei wurde der Verschleisswiderstand mit einem Präzisionsverschleisstester des Fraunhoferinstituts-IST/Braunschweig ermittelt, wobei ein von dem in DIN EN 1071-2 ausgehendes modifiziertes Kalottenschliffverfahren angewandt wurde um die Verschleissrate zu ermitteln. Details zum Verfahren finden sich in Michler, Surf. & Coat. Tech., Vol. 163-164 (2003), Seite 547, Spalte 1 und Fig. 1. Die genannte Schrift wird hiermit zum integralen Bestandteil dieser Anmeldung erklärt.

Die Erfindung wird nun nachfolgend beispielsweise an Hand der Figuren näher erläutert. Es zeigen:
FIG. 1 XRD-Spektren einer AlCrN mit B1 und B4 Struktur
FIG. 2 XRD-Spektren von AlCrN-Schichten in Abhängigkeit von der chem. Zusammensetzung Al/Cr: A=75/25, C=50/50, D=25/75

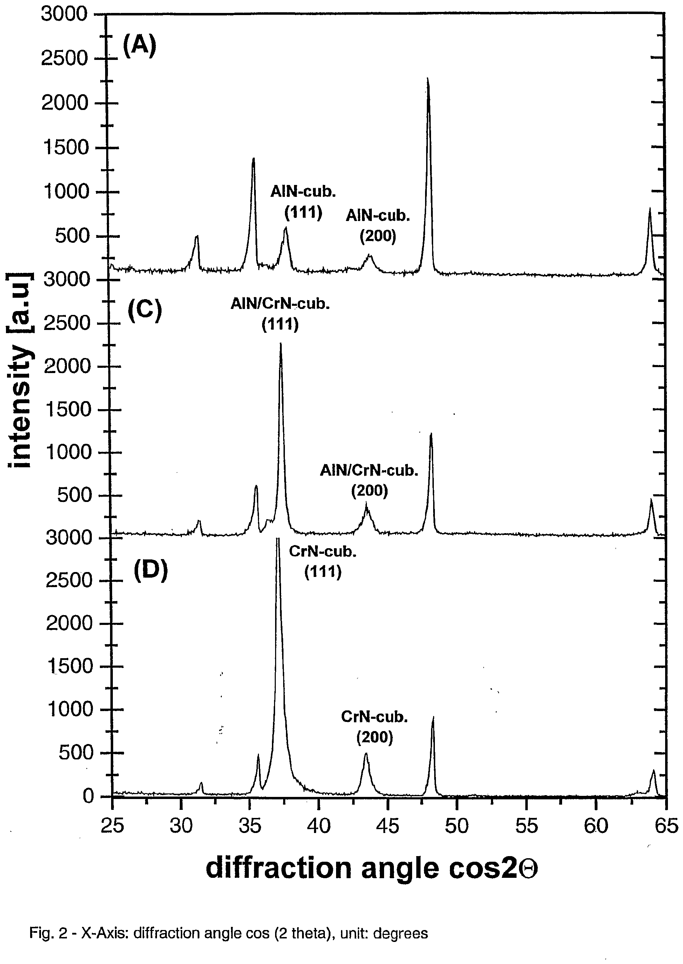

Wie aus Tabelle 1 und Figur 1 ersichtlich und aus Kawate, "Microhardness and lattice parameter of Cr1-xAlxN films" J. Vac. Sci. Technol. A 20(2), Mar/Apr 2002; p 569-571 bekannt ist, konnte für Al-Konzentrationen von grösser 70 At% Anteil am Metallgehalt in der Schicht eine hexagonale (B4) Schichtstruktur und für geringere Al-Konzentrationen eine kubische (B1) Schichtstruktur festgestellt werden. Für hexagonale Schichten konnten HV-Werte von ca. 2100 HV_{0.03}, für kubische Schichtstrukturen jedoch höhere HV-Werte von ca. 2800-3100 HV_{0.03} gemessen werden (siehe Tabelle 1). Bei höheren Cr-Gehalten (Probe D) wurde eine Härte von ca. 2300 HV₀.₀₃ festgestellt. Bei dieser Zusammensetzung liegt im Unterschied zu dem AlN-Gitter der hochaluminiumhaltigen Schichten, wie es in Fig. 2 A dargestellt ist, ein CrN-Gitter wie in Fig. 2D vor.

Anschliessend wurden die Standzeiten von mit AlCrN beschichteten 6 mm HSS-Bohrern auf einem Stahlwerkstoff DIN 1.2080 mit Härte von 230 HB, bei einem Vorschub von 0,12 mm und Schnittgeschwindigkeit von 35 m/min gemäss unten angeführtem Beispiel 1 ermittelt. Dabei zeigte sich, dass, im Gegensatz zu dem in JP 09-041127 als besonders günstig beschriebenen Bereich von AlyCrl-yN 1<y≤0.7, ein Chromgehalt grösser 0.3 sich als vorteilhaft erweist. Bei Cr-Gehalten von grösser oder gleich 0.8 nimmt die Leistungsfähigkeit aufgrund des vorliegenden CrN-Gitters für diesen Anwendungsbereich wieder ab. Die Standzeiterhöhung von kubischem gegenüber hexagonalen AlCrN-Schichten betrug in diesem Test 235%.

Für Schichten in einem Übergangsbereich mit einem Al-Gehalt zwischen 60% und 75at% lässt sich nicht nur die Vorzugsorientierung, sondern auch die grundlegende Struktur des Kristallgitters über die Prozessparameter einstellen. So wird wie beispielsweise im Versuch B (Tabelle 2) bei einem geringen Druck von 1 Pa und einer Substratspannüng von -50 V eine hexagonale Struktur erzeugt, während in einem Druckbereich von 3 Pa und Substratspannung von -50V eine kubische Struktur erzeugt wird. Die hexagonale Struktur wird somit bei verhältnismässig niedriger Biasspannung und niedrigem Druck abgeschieden, wohingegen die bevorzugte kubische Struktur bei höherem Druck bzw. bei dem Betrag nach höherer Biasspanung abgeschieden wird. Bei höheren Al-Gehalten ist es nicht mehr möglich eine kubische Schichtstruktur zu erzeugen.

Erfindungsgemässe Werkstücke zeichnen sich daher durch eine kubische (Al_{y}Cr_{1-y}) X Beschichtung mit folgender Zusammensetzung aus: X = N, und Y= 0.66. Die Schichtstruktur ist dabei mikorkristallin mit einer mittleren Korngrösse von ca. 20-120 nm.

Verfahren zeichnen sich durch eine Verfahrensführung aus, bei der eine kubische (Al_{y}Cr_{1-y}) X Schicht mit einer wie oben definierten Zusammensetzung abgeschieden wird. Für das beschriebene kathodische Arcverfahren können vorteilhaft Targetzusammensetzungen von 75 bis 15% Aluminiumgehalt verwendet werden. Bei hohen Aluminiumgehalten sind die Prozessparameter wie oben beschrieben einzustellen, um eine kubische Kristallstruktur zu erzeugen.

Vorteilhaft ist dabei die Verwendung von pulvermetallurgischen, insbesondere durch Kaltpressen hergestellten Targets, die eine höhere Festigkeit aufweisen können als schmelz- oder sintermetallurgisch hergestellte AlCr-Targets, die besonders bei hohen Al-Gehalten meist Sprödphasen enthalten.

Solche Targets werden durch Mischen der pulverförmigen Ausgangsmaterialien kaltgepresst und anschliessend durch mehrmaliges Umformen, beispielsweise in einer Schmiedepresse, bei Temperaturen unter 660°C unter Fliessen und Kaltverschweissen verdichtet und in einen Endzustand mit einer theoretischen Dichte von etwa 96 - 100% gebracht.

Weiters konnte festgestellt werden, dass bei einer AlCrN-Beschichtung, die beispielsweise mit Targets der Zusamensetzung Al/Cr=3 abgeschieden wurde, durch die Substratvorspannung der Verschleisswiderstand beeinflusst werden kann. Mit steigender Substratvorspannung nimmt der Widerstand gegen den Abrasivverschleiss ab (siehe Tabelle 3). Schon bei einer sehr kleinen, in der Tabelle nicht explizit aufgeführten negativen Substratspannung, von nur wenigen Volt (3 - 10 V und beliebige Zwischenwerte) lässt sich eine deutliche Verbesserung gegenüber floatenden Substraten (keine externe Spannungsversorgung) erreichen. Bei ca. -20 V erreicht der Verschleisswiderstand für Al/Cr=3 ein Maximum und fällt bei höheren Spannungen wieder ab. Aus den Versuchen zur Ermittlung des Verschleissverhaltens lässt sich ein optimaler Bereich der Substratspannung zwischen 3 bis 150 V, insbesondere zwischen 5 und 40 V ableiten, in denen eine sehr kleine Verschleissrate zwischen 0,4 und 1,0, insbesondere zwischen 0,4 und 0,8 m³m⁻¹N⁻¹10⁻¹⁵ gemessen wurde. Ähnliches gilt auch für erfindungsgemässe d.h. kubische Schichten unterschiedlicher Al/Cr-Zusammensetzung bei denen keine Verschleissraten über 1.5 m³m⁻¹N⁻¹10⁻¹⁵ gemessen wurden. Allerdings ist zu bemerken, dass auch der Verschleisswiderstand von floatenden und mit hoher Substratspannung abgeschiedenen Schichten wesentlich grösser ist als der Verschleisswiderstand von bekannten TiAlN-Schichten, deren Verschleisskoeffizient deutlich höher ist. Beispielsweise wurde für eine analog zu den AlCrN-Schichten abgeschiedene TiAlN-Schicht (Experiment 2, Al 47 at%, Ti 53 at%) eine Verschleissrate von 3,47 m³m⁻¹N⁻¹10⁻¹⁵ gemessen.

Durch das oben beschriebene Verfahren, insbesondere durch die Verwendung von pulvermetallurgisch hergestellten TiAl-Targets, konnten Schichten mit einer geringen Rauhigkeit abgeschieden werden. Die gemessene Ra-Werte liegen im Bereich zwischen 0,1 und 0,2 µm und bewegen sich somit im selben Bereich wie vergleichbar hergestellte CrN-Schichten. Eine weitere Glättung der Schichten ergab sich bei Verwendung einer zwei entgegengesetzt gepolte Magnetsysteme umfassende Magnetfelderzeugungsvorrichtung die so ausgebildet ist, dass die senkrecht zur Oberfläche stehende Komponente B_{⊥} des resultierenden Magnetfelds über einen Grossteil der Oberfläche im wesentlichen konstant kleine Werte aufweist oder Null ist. Dabei wurden die Werte der senkrechten Magnetfeldkomponente B_{⊥} kleiner 30, bevorzugt kleiner 20, insbesondere bevorzugt kleiner 10 Gauss eingestellt. Die Ra-Werte der damit abgeschiedenen (Al_{y}Cr_{1-y}) X-Schichten lagen im Bereich von 0,05 und 0,15 µm. Das Magnetfeld wurde dabei durch zwei entgegengesetzt gepolte, koaxial hinter dem Target angeordnete Spulen erzeugt.

Weiters können bei der Abscheidung von (Al_{y}Cr_{1-y}) X Schichten auch andere bevorzugt gut leitende, nitridische bzw. auch metallische Haftschichten verwendet bzw. auf eine solche Haftschicht für bestimmte Anwendungen auch verzichtet werden. Beispielsweise kann, zur Erzielung einer besonders hohen Produktivität, eine AlCr-/AlCrN- statt einer TiN-Haftschicht aufgebracht werden, wodurch es möglich ist, alle Arcquellen einer Beschichtungsanlage mit AlCr-Targets zu versehen und die Beschichtungsrate zu erhöhen.

Ebenso ist eine Abscheidung von Gradientenschichten mit beispielsweise gegen die Oberfläche zunehmendem Al-Gehalt möglich, wenn zwei Targettypen mit unterschiedlichem Al/Cr-Verhältnis benutzt werden oder ausgehend von einer Cr- und/oder CrN-Haftschicht durch beispielsweise kontinuierliche oder stufenweise Regelung der entsprechenden Targetleistungen einer sowohl mit Cr- als auch mit AlCr-Targets ausgerüsteten Beschichtungskammer eine Änderung in der Schichtzusammensetzung erzielt wird. Wesentlich für eine industrielle Anwendung solcher Schichtsysteme ist dabei die Möglichkeit die Prozessparameter im wesentlichen über den gesamten Beschichtungsverlauf und damit über die gesamte Schichtdicke reproduzierbar einzustellen. Minimale Schwankungen in der Zusammensetzung, wie sie durch die Substratbewegung beispielsweise auf einem einfach oder mehrfach rotierenden Substratträger bewirkt werden, können dabei zusätzlich zu einer teilweise oder über die gesamte Schichtdicke ausgebildeten Nanostrukturierung - d. h. Lamellierung im Nano- bzw. Mikrometerbereich - genutzt werden. Dabei wird verfahrensbedingt bei Verwendung von unlegierten Chrom- und Aluminiumtargets eine gröber strukturierte Hartschicht abgeschieden als bei Verwendung von legierten AlCr-Targets.

Wenig geeignet sind hierfür jedoch aus dem Stand der Technik bekannte Prozesse, bei denen beispielsweise der Verdampfungsprozess zumindest einer Komponente schwer beherrschbar oder diskontinuierlich ist, da damit keine reproduzierbare Schichtqualität erzielbar ist.

Selbstverständlich ist es auch möglich derartige Schichten auf anderen Vakuumbeschichtungsanlagen bzw. beispielsweise auch durch Sputterprozesse herzustellen, wobei aber die prinzipiell bei Sputterprozessen geringere Ionisierung des Prozessgases unter Umständen durch bekannte Massnahmen wie spezielle Haftschichten, zusätzliche Ionisierung etc. auszugleichen ist um eine vergleichbare Schichthaftung zu erreichen.

Grundsätzlich können mit derartigen Cr₁₋ₓAlₓN Schichten mit kubischer Struktur ganz unterschiedliche Werkstücke vorteilhaft beschichtet werden. Beispiele dafür sind Schneidwerkzeuge wie Fräser, Abwälzfräser, Kugelkopf-, Planar- und Profilfräser, sowie Bohrer, Gewindebohrer, Räumwerkzeuge, Reibahlen und Wendeschneidplatten für Dreh- und Fräsbearbeitungen bzw. Umformwerkzeuge wie beispielsweise Stempel, Matrizen, Ziehringe, Auswurfkerne oder Gewindeformer. Auch Spritzgusswerkzeuge beispielsweise für metallische Spritzgusslegierungen, Kunstharze oder thermoplastische Kunststoffe, insbesondere Spritzgusswerkzeuge wie sie zum Herstellen von Kunststoffformteilen bzw. Datenträgern wie CDs, DVDs u.a. verwendet werden, können vorteilhaft mit derartigen Schichten geschützt werden. Ein weiterer Anwendungsbereich sind Bauteile bei denen grosse Anforderungen an die Verschleissbeständigkeit, unter Umständen gepaart mit hoher Oxidationsbeständigkeit, zu stellen sind. Beispiele aus dem Pumpen- bzw. Motorenbau dafür sind Dichtringe, Kolben, Stempel, Zahnräder und Ventiltriebe wie beispielsweise Tassenstössel und Kipphebel, bzw. Nadeln für Einspritzdüsen, Kompressorenwellen, Pumpenspindeln, bzw. viele Bauteile an denen ein oder mehrere Verzahnungselemente angebracht sind.

Weiters ist auf Grund des prinzipiell ähnlichen Verhaltens von (Al_{y}Cr_{1-y}) X Schichten auch eine Verbesserung des Verschleissverhaltens zu erwarten, wenn bei folgenden Schichtsystemen Targetzusammensetzung und Beschichtungsparameter so gewählt werden, dass eine kubische Schichtstruktur erzielt wird.

(Al_{y}Cr_{1-y}) X Schichten, wobei X = N und Y = 0.66 ist.

So wurden (Al₆₆Cr₃₄) NO Schichten mit unterschiedlichem N/O-Verhältnis abgeschieden und deren Schichteigenschaften getestet. Die Beschichtungsparameter wurden ähnlich wie oben gewählt. Der Gesamtdruck wurde zwischen 1 bis 5 Pa bei einem Sauerstofffluss zwischen 20 und 60 sccm (Rest Stickstoff), die Substratspannung zwischen -40 bis -150 V, die Temperatur auf 450°C und die Quellenleistung bei einem Strom von 140 A auf 3.5 kW eingestellt. Dabei wurden Schichten mit einem O/N-Verhältnis von ca. 0.2, 0.6 und 2.2 hergestellt. In verschiedenen Frästests zeigten sich dabei die Schichten mit geringerem Sauerstoffgehalt überlegen. Die Ergebnisse lagen deutlich über den mit herkömmlichen TiN bzw. TiCN erreichten Standzeiten.

Durch die gegenüber bekannten TiAlN-Schichten verbesserten Gleiteigenschaften obiger (Al_{y}Cr_{1-y}) X Schichten ergibt sich eine unter ökologischen wie auch unter ökonomischen Gesichtspunkten interessante Möglichkeit beim Betrieb von Werkzeugen, insbesondere von Schneidwerkzeugen und Umformwerkzeugen, auf Schmiermittel entweder zu verzichten oder nur Minimal-Schmiermittelmengen einzusetzen. Unter ökonomischen Aspekten ist dabei zu berücksichtigen, dass die Kosten für kühlendes Schmiermittel insbesondere bei Schneidewerkzeugen um etliches höher liegen können als für das Werkzeug selbst.

Eine noch weiterführende Möglichkeit die Gleiteigenschaften eines erfindungsgemässen, eine (Al_{y}Cr_{1-y}) X Schicht enthaltenden Schichtsystem zu verbessern ergibt sich, wenn als äusserste Schicht zusätzlich eine Gleitschicht aufgebracht wird. Dabei ist es vorteilhaft, wenn die Gleitschicht eine geringere Härte als die (Al_{y}Cr_{1-y}) X Schicht aufweist und Einlaufeigenschaften besitzt.

Das Gleitschichtsystem, kann dabei aus mindestens einem Metall oder einem Karbid mindestens eines Metalles und dispersem Kohlenstoff, MeC/C aufgebaut sein, wobei das Metalle ein Metall der Gruppe IVb, Vb und/oder VIb und/oder oder Silizium ist. Beispielsweise eignet sich hierfür besonders eine WC/C-Deckschicht mit einer zwischen 1000 und 1500 HV einstellbaren Härte, die ausgezeichnete Einlaufeigenschaften aufweist. Auch CrC/C-Schichten zeigen ein ähnliches Verhalten, bei einem allerdings etwas höheren Reibkoeffizienten.

Bei derartig beschichteten Tieflochbohrern konnte nach Herstellung von ein bis drei Bohrlöchern eine ausgezeichnete Einlaufglättung der Spanflächen festgestellt werden, die bis jetzt nur durch eine aufwändige mechanische Bearbeitung erzeilt werden konnte. Interessant sind solche Eigenschaften auch besonders für Bauteilanwendungen mit Gleit-, Reib- bzw. Rollbeanspruchung, insbesondere unter Mangelschmierung oder Trockenlauf, oder wenn gleichzeitig ein unbeschichteter Gegenkörper geschützt werden soll.

Weitere Möglichkeiten zur Bildung einer abschliessenden Gleitschicht sind metallfreie diamantähnliche Kohlenstoffschichten, bzw. MoSₓ-, WSₓ- oder titanhaltige MoSₓ- bzw. MoWₓ-Schichten.

Die Gleitschicht kann dabei wie erwähnt direkt auf der (Al_{y}Cr_{1-Y}) X Schicht oder nach Aufbringen einer weiteren Haftschicht, die metallisch, nitridisch, carbidisch, carbonitridisch oder auch als Gradientenschicht mit beispielsweise kontinuierlichem Übergang zwischen (Al_{y}Cr_{1-y}) X- und Gleitschicht ausgebildet sein kann, aufgebracht werden, um eine möglichst gute Haftung des Schichtverbunds zu bewirken.

Beispielsweise können WC/C- bzw. CrC/C-Schichten nach Aufbringen einer gesputterten oder gearcten Cr- bzw. Ti-Haftschicht vorteilhaft durch Sputtern von WC-Targets unter Zugabe eines kohlenstoffhaltigen Gases hergestellt werden. Dabei wird der Anteil des kohlenstoffhaltigen Gases mit der Zeit erhöht um eine grösseren Anteil an freien Kohlenstoff in der Schicht zu erzielen.

Im Folgenden werden weitere vorteilhafte Anwendungen unterschiedlicher (Al_{y}Cr_{1-y}) X hartbeschichteter Werkzeuge beispielhaft am Einsatz für verschiedene Schneidoperationen dargestellt.

### Beispiel 1: Fräsen von Baustahl

Werkzeug: Schaftfräser Hartmetall
Durchmesser D = 8 mm, Zähnezahl z = 3
Werkstoff: Baustahl Ck45, DIN 1.1191
Fräsparameter:
   Schnittgeschwindigkeit v_{c} = 200/400 m/min
Vorschubgeschwindigkeit v_{f} = 2388/4776 mm/min
radiale Eingriffsbreite aₑ = 0,5 mm
axiale Eingriffsbreite aₚ = 10 mm
Kühlung: Emulsion 5%
Prozess: Gleichlauffräsen
Verschleisskriterium: Freiflächenverschleiss VB = 0,12 mm

| Experiment Nr. | Metallanteil [At%] Schicht | | | Standzeit t bei VB = 0,12 mm in Minuten | |
|---|---|---|---|---|---|
| | Ti | Al | Cr | v_{c} = 200 m/min | v_{c} = 400 m/min |
| 1 (TiCN) | 100 | - | - | 71 | 9 |
| 2 (TiAlN) | 53 | 47 | - | 42 | 15 |
| 3 (AlCrN)B1 | - | 69,5 | 30,5 | 167 | 40 |
| 4 (AlCrN)B4 | | 72 | 28 | 41 | 7 |
| 5 (AlCrN)B1 | - | 41,5 | 58,5 | 150 | 12 |
| 6 (AlCrN)B1 | - | 19 | 81 | 17 | 4 |

Beispiel 1 zeigt einen Vergleich der Standzeiten von beschichteten HM-Fräsern, die bei unterschiedlichen Schnittparametern getestet wurden.

Dabei ist deutlich erkennbar, dass im Vergleich zu den bisher industriell verwendeten Schichtsystemen, wie TiCN und TiAlN, die erwähnten AlCrN-Schichten höhere Standzeiten aufweisen. Weiters ist aus den Ergebnissen ersichtlich, dass wie schon bei Beispiel 1 mit steigendem Al-Gehalt, soweit die kubische B1-Struktur erhalten bleibt, sich das Standzeitverhalten verbessert (Vergleich Experiment Nr. 3, 5, 6). Dies ist vor allem auf die mit steigendem Al-Gehalt festzustellende verbesserte Oxidationsbeständigkeit und Härte (siehe Tabelle 1) zurückzuführen. Gerade im Bereich der Trocken- und Hochgeschwindigkeitsbearbeitung (z.B. v_{c} = 400 m/min) kommt die sehr gute Oxidationsbeständigkeit der AlCrN-Beschichtung zum Tragen. Darüberhinaus ist auch bei diesem Test festzustellen, dass sich beim Umklappen des Kristallgitters von B1 auf B4 Struktur das Verschleissverhalten verschlechtert (Vergleich Experiment 3 und 4).

### Beispiel 2: Fräsen von austenitischem Stahl

Werkzeug: Schaftfräser Hartmetall
Durchmesser D = 8 mm, Zähnezahl z = 3
Werkstoff: austenitischer Stahl X 6 CrNiMoTi' 17 12 2, DIN 1.4571
Fräsparameter:
   Schnittgeschwindigkeit v_{c} = 240 m/min
Zahnvorschub f_{z} = 0,08 mm
radiale Eingriffsbreite aₑ = 0,5 mm
axiale Eingriffsbreite aₚ = 10 mm
Kühlung: Emulsion 5%
Prozess: Gleichlauffräsen
Verschleisskriterium: Freiflächenverschleiss VB = 0,1 mm

| Experiment Nr. | Metallanteil [At%] Schicht | | | Standweg l_{f} bei VB = 0,1 mm in Meter |
|---|---|---|---|---|
| | Ti | Al | Cr | |
| 7 (TiCN) | 100 | - | - | 33 |
| 8 (AlTiN) | 35 | 65 | - | 45 |
| 9 (AlCrN) B1 | - | 69,5 | 30,5 | 54 |

Beispiel 2 zeigt einen Vergleich der Standzeiten von beschichteten HM-Fräsern. Hier konnte ebenfalls mit der AlCrN-Schicht gegenüber industriell verwendeten Hartstoffschichten eine Verbesserung des Verschleisses erzielt werden. Die Standzeitverbesserung bei AlCrN könnte zum einen durch eine bis jetzt noch nicht bewiesene, im Vergleich zu Ti bei TiAlN-Schichten, geringere Neigung des zweiten Legierungselementes Cr zu Materialaufschmierung und zum anderen durch den wie in Tabelle 1 ersichtlichen guten Verschleisswiderstand erfindungsgemässer AlCrN-Schichten (A, B, D), bei gleichzeitiger hoher Härte erreicht werden.

### Beispiel 3: Fräsen von gehärtetem Stahl

Werkzeug: Kugelkopffräser Hartmetall
Durchmesser D = 10 mm, Zähnezahl z = 2
Werkstoff: K340 (62HRC) entspricht C 1,1%, Si 0.9%, Mn 0,4%, Cr 8,3%, Mo 2,1%, Mo2.1%, V0,5%.
Fräsparameter:
   Schnittgeschwindigkeit v_{c} = 0 - 120 m/min
Zahnvorschub f_{z} = 0,1 mm
radiale Eingriffsbreite aₑ = 0,2 mm
axiale Eingriffsbreite aₚ = 0,2 mm
Kühlung: trocken
Prozess: Gleich- und Gegenlauffräsen, Schlichten
Verschleisskriterium: Freiflächenverschleiss VB = 0,3 mm

| Experiment Nr. | Metallanteil [At%] Schicht | | | Standweg l_{f} bei VB = 0,3 mm in Meter |
|---|---|---|---|---|
| | Ti | Al | Cr | |
| 10 (TiAlN) | 53 | 47 | - | 70 |
| 11 (AlCrN) B1 | - | 69,5 | 30,5 | 90 |

### Beispiel 4: Schruppfräsen von Werkzeugstahl

Werkzeug: Schaftfräser Hartmetall
Durchmesser D = 10 mm, Zähnezahl z = 4
Werkstoff: Werkzeugstahl X 38 CrMoV 5 1, DIN 1.2343 (50HRC)
Fräsparameter: Schnittgeschwindigkeit v_{c} = 60 m/min
Zahnvorschub f_{z} = 0,02 mm
radiale Eingriffsbreite aₑ = 2 mm
axiale Eingriffsbreite aₚ = 10 mm
Kühlung: trocken
Prozess: Gleichlauffräsen, Schruppen
Verschleisskriterium: Freiflächenverschleiss VB = 0,1 mm

| Experiment Nr. | Metallanteil [At%] Schicht | | | Standweg l_{f} bei VB = 0,1 mm in Meter |
|---|---|---|---|---|
| | Ti | Al | Cr | |
| 12 (AlTiN) | 35 | 65 | - | 90 |
| 13 (AlCrN) B1 | - | 69,5 | 30,5 | 130 |

Beispiel 3 und Beispiel 4 zeigen einen verbesserten Standweg der AlCrN-Schichten gegenüber den industriell verwendeten TiAlN-Schichten. AlCrN eignet sich d.h. auch besonders für die Trockenbearbeitung, die hohe Anforderungen hinsichtlich der Oxidationsbeständigkeit und des Verschleisswiderstandes stellt.

### Beispiel 5: Bohren in Werkzeugstahl

Werkzeug: Bohrer HSS (S 6-5-2), Durchmesser D = 6 mm
Werkstoff: Werkzeugstahl X 210 Cr 12, DIN 1.2080 (230HB)
Bohrparameter:
   Schnittgeschwindigkeit v_{c} = 35 m/min
Vorschub f = 0,12 mm
Bohrlochtiefe z = 15 mm, Grundloch
Kühlung: Emulsion 5%
Verschleisskriterium: Drehmomentabschaltung (entspricht einem Ekkenverschleiss von ≥ 0,3 mm)

| Experiment Nr. | Metallanteil [At%] Schicht | | Standweg [Lochzahl / µm Schichtdicke] |
|---|---|---|---|
| | Al | Cr | |
| 14 (AlCrN) B1 | 19 | 81 | 21 |
| 15 (AlCrN) B1 | 41,5 | 58,5 | 52 |
| 16 (AlCrCN) B1 | 41,5 | 58,5 | 65 |
| 17 (AlCrN) B1 | 69,5 | 30,5 | 108 |
| 18 (AlCrN) B4 | 72 | 28 | 46 |

Beispiel 6 zeigt einen Vergleich der auf die über die Schichtdicke normierte Lochzahl von HSS-Bohren mit AlyCrl-yN / AlyCrl-yCN Schichten unterschiedlichen Al-Gehalts.

Die Schichten wurden mit den Parametern entsprechend Tabelle 2 hergestellt. Dabei zeigt sich mit zunehmendem Aluminiumgehalt eine Steigerung der Standzeit bis knapp 70% Anteil des Aluminiums am Metallgehalt. Bei einer weiteren Erhöhung und damit Abscheidung einer Schicht mit hexagonaler Kristallstruktur fällt allerdings die Leistung deutlich ab. Im Bereich zwischen 41,5 und 69,5% Al (Experiment 15, 17) konnte für diese Anwendung somit eine deutliche Leistungssteigerung gegenüber dem Stand der Technik (Experiment 18) festgestellt werden.

### Beispiel 6: Tieflochbohren 5xD in Ck45

Werkzeug: Bohrer Hartmetall, Durchmesser D = 6,8 mm
Werkstoff: Baustahl 1.1191 (Ck45)
Bohrparameter:
   Schnittgeschwindigkeit v_{c} = 120 m/min
Vorschub f = 0,2 mm
Bohrlochtiefe z = 34 mm, Grundloch
Kühlung: Emulsion 5%
Verschleisskriterium: Eckenverschleiss VB = 0,3 mm

| Experiment Nr. | Metallanteil [At%] Schicht | | | Standzeit t bei VB = 0,3 mm in |
|---|---|---|---|---|
| | Ti | Al | Cr | Anzahl Bohrlöcher |
| 18 (TiAlN) | 70 | 30 | - | 890 |
| 19 (TiAlN) | 53 | 47 | | 1135 |
| 20 (AlCrN)B1 | - | 69,5 | 30,5 | 2128 |

Beispiel 6 zeigt einen verbesserten Standweg der AlCrN-Schicht gegenüber den industriell verwendeten TiAlN-Schichten bei einer Bohranwendung. Hier kommt der verbesserte Abrasiv-Verschleisswiderstand der erfindungsgemässen AlCrN-Beschichtung zu tragen.

Zusätzlich wurden wie in Experiment Nr. 20 beschichtete Bohrer nach Aufbringen einer Cr-Haftschicht mit einer WC/Kohlenstoff-Gleitschicht versehen, wobei unter sonst gleichen Testbedingungen teilweise eine deutlich verbesserte Standzeit erzielt werden konnte. Gleichzeit durchgeführte Drehmomentmessungen ergaben ein deutlich geringeres Drehmoment als ohne Gleitschicht. Weiters konnte an den Bohrlöchern eine bessere Oberflächenqualität und bis kurz vor Standzeitende keine Verfärbung durch übermässige Temperaturbelastung festgestellt werden.

### Beispiel 7: Gewindebohren 2xD in austenistischem Stahl

Werkzeug: Gewindebohrer HSS, Gewindedimension M8
Werkstoff: austenitischer Stahl 1.4571 (X6CrNiMoTi17/12/2)
Schnittparameter:
   Schnittgeschwindigkeit v_{c} = 3 m/min
Gewindetiefe: 2xD
Gewindeart: Sackloch
Anzahl Gewinde: 64
Kühlung: Emulsion 5%
Verschleisskriterium: Drehmomentverlauf über Gewindezahl, optische Verschleissbeurteilung nach 64 Gewinden.

| Experiment Nr. | Metallanteil [At%] Schicht | | | | |
|---|---|---|---|---|---|
| | Ti | Al | Cr | Ø max. Schnittmoment [Nm] | Optischer Verschleiss (1) |
| 21 (TiCN) | 100 | - | - | 4,72 | + |
| 22 (AlCrN)B1 | - | 69,5 | 30,5 | 4,05 | ++ |
| 23 (AlCrN)B1 | - | 41,5 | 58,5 | 4,23 | +++ |
| 24 (AlCrN)B1 | - | 19 | 81 | 4,27 | + |

| | | | | | |
|---|---|---|---|---|---|
| Erläuterung zu (1) + befriedigendes Verschleissverhalten beim Gewindebohren ++ gutes Verschleissverhalten beim Gewindebohren +++ sehr gutes Verschleissverhalten beim Gewindebohren | | | | | |

Bei sämtlichen AlCrN-Schichten kann gegenüber dem Stand der Technik (TiCN) eine Reduzierung des durchschnittlichen maximalen Schnittmomentes erreicht werden. Weiters ergibt sich aufgrund des sehr guten Verschleisswiderstandes der höher aluminiumhaltigen Schichten ein verbessertes Verschleissverhalten gegenüber TiCN. Allerdings zeigt sich in diesem Beispiel vermutlich aufgrund der adhäsiven Neigung des Aluminiums, welche zu Materialaufschmierungen und in weiterer Folge zu Schichtauslösungen führt, die Schicht aus Experiment Nr. 23 ein besseres Verschleissbild als Nr. 22.

Zusätzlich wurden wie in Experiment Nr. 22 und Nr. 23 beschichteten Gewindebohrern nach Aufbringen einer AlCr-Haftschicht mit einer WC/Kohlenstoff-Gleitschicht, bzw. nach Aufbringen einer Ti-Haftschicht mit einer Ti-haltigen MoS₂-Schicht versehen, wobei ebenfalls, unter sonst gleichen Testbedingungen Standzeitverbesserung und eine bessere Oberflächenqualität des bearbeiteten Werkstoffs erreicht werden konnte.

### Beispiel 8: Abwälzfräsen auf Cr-Mo Stahl

Werkzeug: Wälzfräser
Material DIN S6-7-7-10 (ASP60)
Durchmesser D = 80 mm, Länge L = 240 mm, Modul m = 1,5
25 Spannuten
Eingriffswinkel α = 20°,
Bezugsprofil 2, Zahnzahl 50, Gangbreite 25 mm
Werkstoff: Cr-Mo Stahl DIN 34CrMo4
Schnittparameter:
   Schnittgeschwindigkeit v_{c} = 260 m/min
Vorschub 2 mm/U
Stückzahl: 300
Kühlung: trockener Schnitt, Pressluft zur Entfernung der Späne

| Experiment Nr. | Metallanteil [At%] Schicht | | | Verschleissmarkenbreite in [mm] | |
|---|---|---|---|---|---|
| | Ti | Al | Cr | Freiflächenv. | Kolkverschleiss |
| 25 (TiCN) | 100 | - | - | 0,32 | 0,062 |
| 26 (TiAlN) | 53 | 47 | - | 0,25 | 0,042 |
| 27 (AlCrN)B4 | | 72 | 28 | 0,29 | 0,053 |
| 28 (AlCrN)B1 | - | 19 | 81 | 0,26 | 0,051 |
| 29 (AlCrN)B1 | - | 41,5 | 58,5 | 0,13 | 0,022 |
| 30 (AlCrN)B1 | - | 69,5 | 30,5 | 0,14 | 0,018 |

Bei den Versuchen 25 bis 30 wurden verschiedene Abwälzfräser aus pulvermetallurgisch hergestelltem Hochgeschwindigkeitsstahl (HSS) mit unterschiedlichen Schichtsystemen im trockenen Schnitt getestet. Dabei konnte mit beschichteten Werkzeugen (Experiment 29 und 30) eine wesentliche Verbesserungen gegenüber mit bekannten TiCN oder TiAlN beschichteten Fräsern erzielt werden. Ebenso ist zu erkennen, dass AlCrN-Schichten mit geringem (Nr. 28) bzw. zu hohem Al-Gehalt bei Vorliegen einer hexagonalen Kristallstruktur (Nr. 27) einen geringeren Schutz gegen Verschleiss bieten.

Auch die folgenden erfindungsgemäss Beispiele Nr. 31 bis 33 zeigen die deutliche Überlegenheit einer erfindungsgemässen AlCrN-Schicht mit kubischem Kristallgitter, im wesentlichen stöchiometrischem Stickstoffanteil und einem Al-Gehalt von 66%. Dabei wurden aus PM HSS bzw. Hartmetall hergestellte Wälzfräser sowohl im trockenen als auch im emulsionsgeschmierten Schnitt getestet.

### Experiment Nr. 31: Abwälzfräsen

Werkzeug: PM HSS
Durchmesser D = 80 mm, Länge L = 240 mm
Werkstoff: 16 Mn Cr 5
Schnittgeschwindigkeit: 180 m/min, trocken

| | |
|---|---|
| (Al_{0.42}Ti_{0.58})N, Balinit NANO: | 1809 Stück |
| (Al_{0.63}Ti_{0.37})N, Balinit X.CEED: | 2985 Stück |
| (Al_{0.66}Cr_{0.34}) N: | 5370 Stück |

### Experiment Nr. 32: Abwälzfräsen

Werkzeug: Hartmetall (HM)
Durchmesser D = 60 mm, Länge L = 245 mm
Modul: 1.5
Eingriffswinkel □ = 20°
Werkstoff: 42 CrMo4
Schnittgeschwindigkeit: 350 m/min, trocken

| | |
|---|---|
| (Al_{0.41}Ti_{0.59})N, Balinit X.TREME: | 1722 Stück |
| (Al_{0.63}Ti_{0.37})N, Balinit X.CEED: | 2791 Stück |
| (Al₀.₆₆Cr_{0.34})N: | >3400 Stück |

### Experiment Nr. 33: Abwälzfräsen

Werkzeug: PM HSS
Modul 2.5

| | |
|---|---|
| Werkstoff: | 16MnCr5 |

Schittgeschwindigkeit 140 m/min, emulsion

| | |
|---|---|
| TICN, BALINIT B: | 1406 Stück |
| (Al_{0.42}Ti_{0.58}) N, Balinit NANO: | 1331 Stück |
| (Al_{0.66}Cr_{0.34})N: | 1969 Stück |

Weitere, hier nicht näher angeführte Versuche, ergaben auch bei noch höheren Schnittgeschwindigkeitsbereichen, bis zu v_{c} = 450 m/min noch eine gute Standfestigkeit. Auch die Standzeiten von beschichteten Hartmetall-Wälzfräsern konnten sowohl bei der Nassinsbesondere aber auch bei der Trockenbearbeitung deutlich gesteigert werden.

### Beispiel 9: Schruppfräsen von Werkzeugstahl

Werkzeug: Schaftfräser HSS
Durchmesser D = 10 mm, Zähnezahl z = 4
Werkstoff: Werkzeugstahl X 40 CrMoV 5 1, DIN 1.2344 (36HRC)
Fräsparameter:
   Schnittgeschwindigkeit v_{c} = 60 m/min
Zahnvorschub f_{z} = 0,05 mm
radiale Eingriffsbreite aₑ = 3 mm
axiale Eingriffsbreite aₚ = 5 mm
Kühlung: Emulsion 5%
Prozess: Gleichlauffräsen, Schruppen
Verschleisskriterium: Freiflächenverschleiss VB = 0,1 mm

| Experiment Nr. | Metallanteil [At%] Schicht | | | Standweg l_{f} bei VB = 0,1 mm in Meter |
|---|---|---|---|---|
| | Ti | Al | Cr | |
| 34 (AlTi)N | 35 | 65 | - | 6 - 8 |
| 35 (AlTi)N | 58 | 42 | - | 3 - 4 |
| 36 (AlTi)CN | 50 | 50 | - | 3 - 4 |
| 37 TiCN | 100 | - | - | 8 - 11 |
| 38 (AlCr)N | HS | 64 | 36 | 12 - 21 |
| 39 (AlCr)N | puls | 66 | 34 | 21 - 28 |
| 40 (AlCr)N | - | 66 | 34 | 12 - 18 |

- HS: Haftschicht aus TiN
- puls: gepulster Bias

### Beispiel 10: Aussenlängsdrehen von gehärtetem Einsatzstahl:

Werkzeug: Drehmesser mit eingelötetem CBN-Einsatz
Werkstoff: Einsatzstahl 16 MnCr 5, DIN 1.7131 (49 - 62 HRC)
Drehparameter: Hart-Weichbearbeitung mit unterbrochenen Schnitt und teilweise dünner Wandstärke
Kühlung: trocken
Verschleisskriterium: Stückzahl bis zum Erreichen eines Freiflächenverschleisses von VB = 0,1 mm

| Experiment Nr. | Metallanteil [At%] Schicht | | | Standmenge bei VB = 0,1 mm |
|---|---|---|---|---|
| | Ti | Al | Cr | |
| 41 (AlTi)N | 35 | 65 | - | 90 |
| 42 (AlCr)N | | 66 | 34 | 144 |

Ähnliche Ergebnisse wurden auch mit pulvermetallurgisch hergestellten Cermets bestehend aus einer TiN, TiC oder einer Ti(CN)-Hartphase, der in Einzellfällen Molybdän und/oder Tantal zugesetzt wurde, erzielt. Als Binderphase wurde dabei Ni bzw. Ni/Coverwendet.

### Beispiel 11: Gewindeformen in verzinketem Blech

### Experiment Nr. 43:

Werkzeug: HSS M9 Gewindeformer
Werkstoff: DC01 entspricht DIN 1.0330, St 12 ZE

| | |
|---|---|
| Kernlochdurchmesser: | 8,34 mm |
| Schnittparameter: | 55 m/s |
| Drehzahl Schnitt: | 2000U/min |
| Drehzahl Rück: | 3600 U/min |
| Schmierung: | S26 CA |
| TiN: | 3200 Gewinde |
| TiCN: | 3200 Gewinde |
| TiAlN: | 3500 Gewinde |
| (Al_{0.66}Cr_{0.34})N: | 8800 Gewinde |

Versuche mit beschichteten CBN (kubisches Bornitrid) bzw. Cermet Werkzeugen: Wendeschneidplatten aus verschiedenen CBN-Sinterwerkstoffen mit einem CBN-Gehalt zwischen 30-99 Vol%, Rest Bindemittel wurden einerseits mit bekannten TiAlN-Schichten gemäss Experiment 8 und andererseits mit AlCrN-Schichten gemäss Experiment 3, 5 und 6 beschichtet. Allerdings wurde auf Grund des nichtleitenden Charakters des CBN-Sinterwerkstoffs für den Ätz- und Beschichtungsprozess ein gepulster Substratbias im Mittelfrequenzbereich, vorzugsweise in einem Frequenzbereich von 20 bis 250 kHz, angelegt.

Für Werkstoffe mit einem CBN-Gehalt bis zu 90% wurde dabei ein Bindemittelpulver verwendet, das zumindest aus einem der Elemente der folgenden Gruppe besteht: Nitrid, Carbid, Borid und Oxid der Ti-, V- bzw. Cr-Gruppe, d.h. IVa-, Va- und VIa-Elemente sowie Aluminium bzw. Al-Verbindungen.

Für Werkstoffe mit einem CBN-Gehalt bis zu 95% wurde dabei ein Bindemittelpulver verwendet, das aus Titannitrid und zumindest aus einem der Elemente der folgenden Gruppe besteht: Kobalt, Nickel, Wolframcarbid, Aluminium oder eine Aluminiumverbindung.

Für Werkstoffe mit einem CBN-Gehalt grösser 90% wurde auch ein Bindemittelpulver verwendet, das aus Titannitrid und zumindest aus einem der Elemente der folgenden Gruppe besteht: Borid bzw. Boronitrid der Alkali- bzw. Erdalkalimetalle.

Bei anschliessend durchgeführten Dreh- und Fräsversuchen konnte in den meisten Fällen ein gegenüber TiAlN-Schichten deutlich verbessertes Verschleissverhalten festgestellt werden. Ebenso bei einem besonders aufwändigen Aussenlängsdrehversuch, bei dem eine nur partiell gehärtete Welle komplexer Geometrie teilweise im unterbrochenen Schnitt bearbeitet wurde.

### Beispiel 12: Warmschmieden

| | |
|---|---|
| Werkzeug: | Schmiedebacken 4 St, 220x43x30 mm, Böhler W360, Härte 54 HRC, 4 Werkzeuge gleichzeitig im Eingriff |
| Werkstück: | Rundmaterial Durchmesser 22 mm, Material 42CrMo4 |
| Verfahren: | Temperatur Werkstück vor Umformung 1.050°C |
| | Presskraft 57 t/pro Backen |
| | Kühlung: Molicote + Graphit |

| Experiment Nr. | Metallanteil [At%] Schicht | | | | Standmenge (Stückzahl) |
|---|---|---|---|---|---|
| | Ti | Al | Cr | Nb/Si V/W | |
| 43 unbesch. | - | - | - | - | 500 |
| 44 TiAlN | 58 | 42 | - | - | 900 |
| 45 AlCrN | - | 64 | 36 | - | 1900 |
| 46 AlCrVN | - | 63 | 31 | 6 | 1500 |
| 47 AlCrSiN | HS | 65 | 26 | 9 | 1800 |
| 48 AlCrNbN | - | 62 | 31 | 7 | 1550 |
| 49 AlCrWN | - | 65 | 26 | 9 | 1630 |
| 50 AlCrYN | - | 62 | 31 | 7 | 1730 |
| 51 AlCrMoN | - | 62 | 31 | 7 | 1460 |

- HS: Haftschicht aus TiN

### Beispiel 13: Warmbördeln

Werkzeug: HM flowdrill Durchmesser 10 mm
Werkstück: 1.0338
Verfahren: Werkzeug wird mit einer Umdrehung von ca. 2800 U/min, 3000N gegen das Werkkstück gedrückt. Duch die kinetische Energie wird das Werkstück zur Rotglut, d. h. ca. 1000 °C gebracht und umgeformt.

| Experiment Nr. | Metallanteil [At%] Schicht | | | | Standmenge (Stückzahl) |
|---|---|---|---|---|---|
| | Ti | Al | Cr | Nb/Si V/W | |
| 52 unbesch. | - | - | - | - | 500 |
| 53 TiAlN | 58 | 42 | - | - | 900. |
| 54 AlCrN | - | 64 | 36 | - | 1700 |
| 55 AlCrVN | - | 63 | 31 | 6 | 1530 |
| 56 AlCrSiN | HS | 65 | 26 | 9 | 1650 |
| 57 AlCrNbN | - | 62 | 31 | 7 | 1450 |
| 58 AlCrWN | - | 65 | 26 | 9 | 1390 |
| 59 AlCrYN | - | 62 | 31 | 7 | 1660 |
| 60 AlCrMoN | - | 62 | 31 | 7 | 1340 |

- HS: Haftschicht aus TiN

### Beispiel 14: Stanzen

Werkzeug: 1.2379, Langlochstempel 20mm x 10mm
Werkstück: TRIP 700, 1.2 mm Dicke
Verfahren: Scherschneiden, Schneidspalt 10 %, 500 Hub /min, Schneidkraft 20kN.

| Experiment Nr. | Metallanteil [At%] Schicht | | | | Standmenge (Stückzahl) |
|---|---|---|---|---|---|
| | Ti | Al | Cr | Nb/Si V/W | |
| 61 unbesch. | - | - | - | - | 100000 |
| 62 TiAlN | 58 | 42 | - | - | 200000 |
| 63 AlCrN | - | 64 | 36 | - | 350000 |
| 64 AlCrVN | - | 63 | 31 | 6 | 370000 |
| 65 AlCrSiN | HS | 65 | 26 | 9 | 280000 |
| 66 AlCrNbN | - | 62 | 31 | 7 | 300000 |
| 67 AlCrWN | - | 65 | 26 | 9 | 340000 |
| 68 AlCrYN | - | 62 | 31 | 7 | 320000 |
| 69 AlCrMoN | - | 62 | 31 | 7 | 290000 |

- HS: Haftschicht aus TiN

**Tabelle 1**

| Versuchsbez. | Al/Cr-Verhältnis im Target | Kristallstruktur | Al At% | Cr At% | Schichtdicke [µm] | HV 0.03 | AV [m³m⁻¹N⁻¹1 0⁻¹⁵] | Haftung |
|---|---|---|---|---|---|---|---|---|
| A | 3 | B1 | 69.5 | 30.5 | 3.2 | 3100 | 0.8 | HF1 |
| B | 3 | B4 | 72 | 18 | 4.2 | 2100 | 1.0 | HF1 |
| C | 1 | B1 | 41.5 | 58.5 | 3.8 | 2800 | 1.5 | HF1 |
| D | 0.33 | B1 | 19 | 81 | 4.1 | 2300 | 2.5 | HF1 |

**Tabelle 2**

| Versuchsbez. | Al/Cr-Verhältnis im Target | P_{Target} [kW] | U_{Substrat} [V] | p_{N2} [Pa] | Temp. [°C] |
|---|---|---|---|---|---|
| A | 3 | 3 | -50 | 3 | 450 |
| B | 3 | 3 | -50 | 1 | 450 |
| C | 1 | 3 | -50 | 3 | 450 |
| D | 0.33 | 3 | -50 | 3 | 450 |

**Tabelle 3**

| Substratvorspannung [V] | AV [m³m⁻¹N⁻¹10⁻¹⁵] |
|---|---|
| 0 | 1,23 |
| -20 | 0,47 |
| -40 | 0,76 |
| -100 | 0,83 |
| -150 | 1,0 |
| -200 | 1,36 |

## Patentansprüche

1. Werkstück mit einem Schichtsystem das zumindest eine Schicht der Zusammensetzung (Al_{y}Cr_{1-y})X enthält, mit X = N, mit kubischem Kristallgitter, im Wesentlichen stöchiometrischem Stickstoffanteil und einem Al-Gehalt von 66% bzw y = 0,66, wobei die Schichtzusammensetzung innerhalb der Schicht entweder im Wesentlichen konstant ist oder sich über die Schichtdicke kontinuierlich bzw. stufenweise ändert und das Werkstück eines der folgenden Werkzeuge ist, nämlich ein Fräser, insbesondere ein Abwälz-, Kugelkopf-, Planar- oder Profilfräser, ein Räumwerkzeug, eine Reibahle, eine Wendeschneidplätte für Dreh- und Fräsbearbeitungen, ein Form oder ein Spritzgusswerkzeug,

2. Werkzeug nach Anspruch 1, **dadurch gekennzeichnet; dass** das Werkzeug ein Umformwerkzeug, insbesondere ein Stempel, eine Matrize, ein Ziehring, ein Auswurlkern, ein Gewindeformer, ein Stanzwerkzeug ist.

3. Werkzeug nach Anspruch 1, **dadurch gekennzeichnet, dass** das Werkzeug ein Warmumformwerkzeug, insbesondere ein Schmiede ein Bördel, ein Stanzwerkzeug ist,

4. Werkzeug nach Anspruch 1, **dadurch gekennzeichnet, dass** das Werkzeug ein Spritzgusswerkzeug zur Herstellung eines Kunststoffformteils bzw, eines Datenträgers ist.

5. Werkzeug nach Anspruch 1, **dadurch gekennzeichnet, dass** das Werkzeug einen CBN oder Cermet Grundkörper aufweist, bzw eine CBN oder Cermet Wendeschneidplatte ist.

6. Werkstück nach einem der vorhergehenden Ansprüche, **dadurch gekennzeichnet, dass** die Verschleissrate der (Al_{y}Cr_{1-y})X Schicht kleiner oder gleich 1, 5 m³m⁻¹N⁻¹10⁻¹⁵ ist.

7. Werkstück nach einem der vorhergehenden Ansprüche, **dadurch gekennzeichnet, dass** die Vickershärte der (Al_{y}Cr_{1-y})X Schicht 2300 bis 3100 ist.

8. Werkstück nach einem der vorhergehenden Ansprüche, **dadurch gekennzeichnet, dass** die Schichtstruktur der (Al_{y}Cr_{1-y})X Schicht mikrokristallin ist und die mittlere Korngrösse 20-120 nm beträgt.

9. Werkstück nach einem der vorhergehenden Ansprüche, **dadurch gekennzeichnet, dass** zwischen dem Werkstück und der (Al_{y}Cr_{1-y})X Schicht eine Haftschicht aufgebracht ist.

10. Werkstück nach Anspruch 9, **dadurch gekennzeichnet, dass** die Haftschicht zumindest eines der Metalle der IV, V, oder VI Nebengruppe, bzw Aluminium umfasst

11. Werkstück nach Anspruch 10, **dadurch gekennzeichnet, dass** die Haftschicht zumindest ein Nitrid, Carbid bzw. Garbonitrid eines oder mehrerer Metalle der IV, V, oder VI Nebengruppe umfasst.

12. Werkstück nach einem der vorhergehenden Ansprüche, **dadurch gekennzeichnet, dass** auf der zumindest einen (Al_{y}Cr_{1-y})X Schicht zusätzlich eine Gleitschicht abgelegt ist,

13. Werkstück nach Anspruch 12, **dadurch gekennzeichnet, dass** die Gleitschicht ein Karbid mindestens eines Metalles mit dispersem Kohlenstoff. MeC/C, eine diamantähnlichen Kohlenstoffschicht, eine Si- bzw. metallhaltige diamantähnliche Kohlenstoffschicht, eine MoSₓ, eine WSₓ oder eine titanhaltige MoSₓ bzw. MoWₓ-Schicht umfasst.

14. Verfahren zum Bearbeiten eines Werkstoffs, **dadurch gekennzeichnet, dass** ein Werkzeug gemäss Anspruch 1 verwendet wird

15. Verfahren gemäss Anspruch 14, **dadurch gekennzeichnet, dass** die Bearbeitung ohne Zusatz von Schmier- oder Kühlmitteln erfolgt.

16. Verfahren gemäss Anspruch 14 oder 15, **dadurch gekennzeichnet, dass** das Werkzeug ein Hartmetall- oder ein HSS-Abwälzfrässer ist und die Schnittgeschwindigkeit 60 bis 450m/min beträgt

## Claims

1. A work piece with a layer system, which at least contains one layer having the composition (Al_{y}Cr_{1-y})X, wherein X = N, having cubic crystal lattice, essentially stoichiometric nitrogen ratio and a Al content of 66% or y = 0,66, respectively, wherein the layer composition within the layer is either essentially constant or continuously or stepwise changes across the layer thickness, respectively, and the workpiece is one of the following tools, a cutter, especially a hob cutter, ball head cutter, planar or profile cutter, a broaching tool, a reamer, an indexable insert for turning and milling operations, a mold or an injection mold.

2. The tool according to Claim 1, **characterized in that** the tool is a forming die, especially a stamp, a matrix, a draw ring, an ejection core, a forming tap, a die.

3. The tool according to Claim 1, **characterized in that** the tool is a heat forming die, especially a forging tool, a crimping tool, a punching die.

4. The tool according to Claim 1, **characterized in that** the tool is an injection mold tool for the manufacture of a plastic molding part or a data medium, respectively.

5. The tool according to Claim 1, **characterized in that** the tool comprises a CBN or Cermet base body or is a CBN or Cermet indexable insert, respectively.

6. The work piece according to one of the preceding Claims, **characterized in that** the wear rate of the (Al_{y}Cr_{1-y})X layer is smaller or equal to 1,5 m³m⁻¹N⁻¹10⁻¹⁵.

7. The work piece according to one of the preceding Claims, **characterized in that** the Vickers hardness of the (Al_{y}Cr_{1-y})X layer is 2300 to 3100.

8. The work piece according to one of the preceding Claims, **characterized in that** the layer structure of the (Al_{y}Cr_{1-y})X layer is microcrystalline and the average grain size is 120 nm.

9. The work piece according to one of the preceding Claims, **characterized in that** an adhesive layer is applied between the work piece and the (Al_{y}Cr_{1-y})X layer.

10. The work piece according to Claim 9, **characterized in that** the adhesive layer comprises at least one of the metals of the side group IV, V, or VI, or comprises aluminum, respectively.

11. The work piece according to Claim 10, **characterized in that** the adhesive layer comprises at least one nitride, carbide, carbonitride of one or more metals of the side group IV, V, or VI.

12. The work piece according to one of the preceding Claims, **characterized in that** an additional sliding layer is deposited on the at least one (Al_{y}Cr_{1-y})X layer.

13. The work piece according to Claim 12, **characterized in that** the sliding layer comprises a carbide of at least one metal with dispersed carbon, MeC/C, a diamond-like carbon layer, a Si-containing or a metal-containing diamond-like carbon layer, respectively, a MoSₓ layer, a WSₓ layer or a titanium-containing MoSₓ layer or MoWₓ layer, respectively.

14. A process for processing a material, **characterized in that** a tool according to Claim 1 is used.

15. The process according to Claim 14, **characterized in that** processing is done without the addition of lubricating agent or cooling agent.

16. The process according to Claim 14 or 15, **characterized in that** the tool is a hard metal cutter or a HSS hob cutter and the cutting speed is 60 to 450 m/min.

## Revendications

1. Pièce de fabrication avec un système de couches, qui contient au moins une couche de la composition (Al_{y}Cr_{1-y})X, avec X = N, ayant une structure cristalline cubique, sensiblement un teneur en azote stoechiométrique et une teneur en AI de 66% ou y = 0,66, respectivement, dans lequel la composition de couche au sein de la couche soit sensiblement constante soit continument ou progressivement changeant à travers l'épaisseur de couche, respectivement, et le pièce de fabrication est l'un des outils suivants, à savoir une fraise, particulièrement une fraise-mère, une fraise à bout hémisphérique, une fraise à surfacer-dresser ou un fraise à profiler, un outil de brochage, un alésoir, une plaquette de coupe amovible pour le tournage et fraisage, un outil de moulage ou un outil de moulage injecté.

2. Outil selon la revendication 1, **caractérisé par le fait que** l'outil est un outil de déformation, particulièrement un poinçon, une matrice, une bague d'emboutissage, un noyau d'éjection, un taraud par déformation, un outil de poinçonnage.

3. Outil selon la revendication 1, **caractérisé par le fait que** l'outil est un outil de déformation à chaud, particulièrement un outil de forge, un outil de bordage, un outil de poinçonnage.

4. Outil selon la revendication 1, **caractérisé par le fait que** l'outil est un outil de moulage injecté pour la fabrication d'une pièce moulée en matière plastique ou d'un support de données, respectivement.

5. Outil selon la revendication 1, **caractérisé par le fait que** l'outil comprend un corps de base CBN ou Cermet ou une plaquette de coupe amovible CBN ou Cermet, respectivement.

6. Pièce de fabrication selon l'une des revendications précédentes, **caractérisé par le fait que** le taux d'usure de la couche (Al_{y}Cr_{1-y})X est inférieur ou égal 1,5 m³m⁻¹N⁻¹10⁻¹⁵.

7. Pièce de fabrication selon l'une des revendications précédentes, **caractérisé par le fait que** la dureté Vickers de la couche (Al_{y}Cr_{1-y})X est 2300 à 3100.

8. Pièce de fabrication selon l'une des revendications précédentes, **caractérisé par le fait que** la structure de couche de la couche (Al_{y}Cr_{1-y})X est microcristalline et la taille de grains moyenne est 120 nm.

9. Pièce de fabrication selon l'une des revendications précédentes, **caractérisé par le fait que** entre la pièce de fabrication et la couche (Al_{y}Cr_{1-y})X une couche adhésive est appliquée.

10. Pièce de fabrication selon la revendication 9, **caractérisé par le fait que** la couche adhésive comprend au moins l'un des métaux de la sous-groupe IV, V, ou VI ou de l'aluminium.

11. Pièce de fabrication selon la revendication 10, **caractérisé par le fait que** la couche adhésive comprend au moins un ou plusieurs métaux de la sous-groupe IV, V, ou VI.

12. Pièce de fabrication selon l'une des revendications précédentes, **caractérisé par le fait que** sur l'au moins une couche (Al_{y}Cr_{1-y})X une couche de glissement additionnelle est déposée.

13. Pièce de fabrication selon la revendication 12, **caractérisé par le fait que** la couche de glissement comprend un carbure d'au moins un métal avec du carbone dispersé, MeC/C, une couche de carbone diamantaire, une couche de carbone diamantaire contenant Si ou un métal, respectivement, une couche MoSₓ, WSₓ ou une couche MoSₓ ou MoWₓ contenant du titane.

14. Procédé de traitement pour une pièce de fabrication, **caractérisé par le fait qu'**un outil selon la revendication 1 sera utilisé.

15. Procédé selon la revendication 14, **caractérisé par le fait que** le traitement est fait, sans addition de d'agent lubrifiant et refroidissant.

16. Procédé selon la revendication 14 ou 15, **caractérisé par le fait que** l'outil est un métal dur ou une fraise-mère HSS et la vitesse de coupe est 60 à 450 m/min.
